# EUROPEAN PATENT APPLICATION

(11) **EP 4 772 939 A1**
(43) Date of publication of application: **08.07.2026**
(21) Application number: 24866773.5
(22) Date of filing: 28.02.2024
(51) Int. Cl.: G03B 21/20, G02B 7/182

(54) **SUPPORTING ASSEMBLY AND ASSEMBLY METHOD THEREFOR, AND LIGHT SOURCE DEVICE**

(30) Priority: 20.09.2023 CN 202311220664
(71) Applicant: YLX Incorporated, Shenzhen, Guangdong 518000 (CN)
(72) Inventor: CHEN, Bin, Shenzhen, Guangdong 518000 (CN); QIU, Hanliang, Shenzhen, Guangdong 518000 (CN); FU, Wenbo, Shenzhen, Guangdong 518000 (CN)
(74) Representative: Noréns Patentbyrå AB
(86) International application number: PCT/CN2024/078932
(87) International publication number: WO 2025/060346

(57) **Abstract**

Provided in the present invention are a supporting assembly and an assembly method therefor, and a light source device. The supporting assembly may comprise a supporting member and a light guiding element, wherein the light guiding element can be disposed at the position of a mounting surface of the supporting member corresponding to a mounting hole. By means of providing the mounting hole on the mounting surface of the supporting member and arranging the light guiding element on the mounting surface and covering the mounting hole, when a second bottom surface of the light guiding element is in a state in which the pressure of air in the mounting hole is less than the pressure of air outside the mounting hole, the light guiding element can be pre-fixed on the supporting member, and then the supporting member and the light guiding element are fixed by means of dispensing glue, such that the precision of the positional arrangement of the light guiding element is improved, and thus the reflection precision of the light guiding element is improved. The assembly method for the supporting assembly provided in the embodiments of the present application improves the assembly convenience of the supporting assembly. The light source device applied to the supporting assembly improves the light emission precision.

## Description

### TECHNICAL FIELD

The present disclosure relates to the technical field of projection equipment, and in particular, to a support assembly, a method for assembling a support assembly, and a light source device.

### BACKGROUND

Surface Mount Devices (SMD) lasers, due to the characteristic of small size, have been widely used in fields such as consumer electronic products, automotive electronics, and medical devices. The more cutting-edge the field is, the higher the precision requirement for a light source device is, and the precision of the light source device mainly depends on the mounting precision of a light guiding element.

However, in existing support assemblies, during the mounting process, the light guiding element is extremely prone to displacement due to having a relatively small volume, resulting in the mounting precision of the light guiding element is not high, which not only affects the mounting convenience of the support assembly, but also affects the light emitting precision of the light source device.

### SUMMARY

Embodiments of the present disclosure provides a support assembly, a method for assembling the same and a light source device, so as to at least partially improve the above problems.

The embodiments of the present disclosure are implemented using the following technical solutions.

In a first aspect, an embodiment of the present disclosure provides a support assembly, including: a support member and a light guiding element. The support member includes a first bottom surface and a mounting surface, the mounting surface is arranged obliquely relative to the first bottom surface, the support member is provided with a mounting hole, and the mounting hole at least penetrates through the mounting surface. The light guiding element has a second bottom surface, the second bottom surface is provided on the mounting surface and covers the mounting hole, the second bottom surface covers the mounting hole in a state where an air pressure inside the mounting hole is less than an air pressure outside the mounting hole, and the light guiding element is configured to change a traveling direction of a light beam incident on the light guiding element.

In some embodiments, the air pressure inside the mounting hole at the second bottom surface being less than the air pressure outside the mounting hole includes: the mounting hole is under vacuum.

In some embodiments, the mounting hole further penetrates through the first bottom surface.

In some embodiments, the support member further includes a first top surface opposite to the first bottom surface, and two ends of the mounting surface are respectively connected to the first bottom surface and the first top surface.

In some embodiments, a cross section of the mounting surface encloses to form a regular polygonal structure.

In some embodiments, the light guiding element is further configured to converge the light beam incident on the light guiding element.

In some embodiments, a plurality of mounting surfaces and a plurality of light guiding elements are provided, the light guiding elements are in one-to-one correspondence with the plurality of mounting surfaces, and inclination angles between each of the mounting surfaces and a corresponding first bottom surface are equal.

In some embodiments, at least a partial region of the second bottom surface is configured as a reflective surface.

In some embodiments, the light guiding element further includes a second top surface opposite to the second bottom surface.

In some embodiments, the second top surface is configured to transmit the light beam and the second bottom surface is configured to reflect the light beam.

In some embodiments, the second top surface is configured as a curved surface, and converges, diverges or collimates the light beam.

In some embodiments, the top surface is configured to reflect the light beam.

In some embodiments, the top surface is configured as a plane; or the top surface is configured as a curved surface, and converges, diverges or collimates the light beam.

In some embodiments, an area of the mounting hole is smaller than an area of the second bottom surface.

In some embodiments, the support member is made of ceramic.

In a second aspect, an embodiment of the present disclosure further provides a method for assembling a support assembly, including following steps: providing a support member, the support member includes a bottom surface and a mounting surface, the mounting surface is arranged obliquely relative to the bottom surface, the support member is provided with a mounting hole, and the mounting hole at least penetrates through the mounting surface; placing a plurality of light guiding elements in one-to-one correspondence on the mounting surface of the support member to cover the mounting hole; evacuating the mounting hole to pre-position the light guiding element on the support member; fixing the light guiding element and the support member by applying an adhesive, and stopping the evacuating.

In a third aspect, an embodiment of the present disclosure further provides a light source device, including: the support assembly, the excitation light sources and the wavelength conversion device that are described above. The excitation light source is configured to emit excitation light toward the light emitting element. The wavelength conversion device is configured to receive the excitation light converged by the light guiding element and convert the excitation light into converted light.

In some embodiments, the light source device further includes: a tube shell and a light-transmissive upper cover. The light-transmissive upper cover is arranged on the tube shell and encloses a closed space with the tube shell. The excitation light source and the support assembly are arranged in the closed space, and the excitation light reflected by the light guiding element is incident to the wavelength conversion device through the light-transmissive upper cover.

According to the support assembly provided by the embodiments of the present disclosure, the mounting hole is arranged on the mounting surface of the support member, and the light guiding element is arranged on the mounting surface and covers the mounting hole. When the second bottom surface of the light guiding element is in a state in which the air pressure inside the mounting hole is less than the air pressure outside the mounting hole, the light guiding element can be pre-fixed to the support member, and then the support member is fixed to the light guiding element by applying an adhesive, thereby improving the accuracy of the arrangement position of the light guiding element, and further improving the reflection accuracy of the light guiding element. According to the method for assembling the support assembly provided by the embodiments of the present disclosure, the support member is first placed on the vacuum platform, then the light guiding element is placed on the mounting surface of the support member and cover the mounting hole provided on the mounting surface, then the evacuating is performed on the mounting hole to pre-position the light guiding element on the support member, then the light guiding element is fixed to the support member by applying an adhesive, and finally the evacuating is stopped, thereby improving the convenience of assembling the support assembly. The light source device applied to the support assembly improves the light emitting accuracy.

### BRIEF DESCRIPTION OF DRAWINGS

In order to more clearly illustrate the technical solutions in the embodiments of the present disclosure, the drawings required in the description of the embodiments will be briefly described below. It is clear that, the drawings in the following description are only some embodiments of the present disclosure, and for those skilled in the art, other drawings may also be obtained according to these drawings without any creative effort.
FIG. 1 is a schematic structural diagram of a light source device according to an embodiment of the present disclosure.
FIG. 2 is a schematic structural diagram of a support assembly according to an embodiment of the present disclosure.
FIG. 3 is a schematic structural diagram of a support member in a support assembly according to an embodiment of the present disclosure.
FIG. 4 is a flowchart of a method for assembling a support assembly according to an embodiment of the present disclosure.

Reference signs: light source device 1, support assembly 10, support member 110, first bottom surface 111, first top surface 112, mounting surface 113, mounting hole 113a, light guiding element 120, second bottom surface 121, excitation light source 20, wavelength conversion device 30, tube shell 40, bottom plate 410, side plate 420, and light-transmissive upper cover 50.

### DESCRIPTION OF EMBODIMENTS

To make those skilled in the art better understand the solutions of the present disclosure, the technical solutions in the embodiments of the present disclosure will be clearly and completely described below with reference to the drawings in the embodiments of the present disclosure. Obviously, the described embodiments are only some rather than all of the embodiments of the present disclosure. All other embodiments obtained by those skilled in the art based on the embodiments of the present disclosure without creative efforts should fall within the protection scope of the present disclosure.

The technical solutions in the embodiments of the present disclosure will be clearly and completely described below in combination with the drawings in the embodiments of the present disclosure.

Surface Mount Devices (SMD) lasers, due to the characteristic of small size, have been widely used in fields such as consumer electronic products, automotive electronics, and medical devices. The more cutting-edge the field is, the higher the precision requirement for a light source device is, and the precision of the light source device mainly depends on the mounting precision of a light guiding element.

However, in existing support assemblies, during the mounting process, the light guiding element is extremely prone to displacement due to having a relatively small volume, resulting in the mounting precision of the light guiding element is not high, which not only affects the mounting convenience of the support assembly, but also affects the light emitting precision of the light source device.

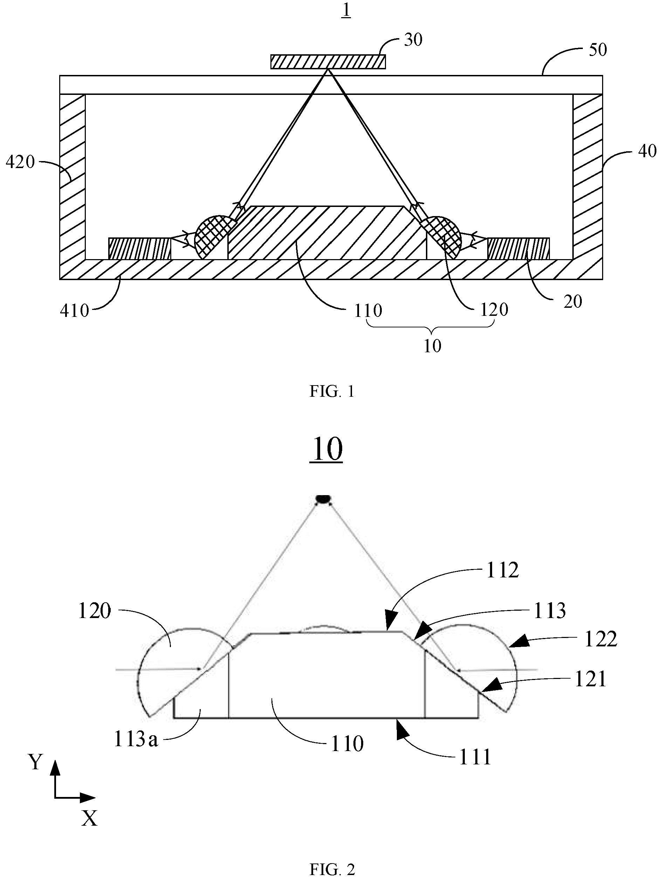

Based on the above technical problem, the present disclosure provides a light source device 1. Referring to FIG. 1, FIG. 1 shows a schematic structural diagram of a light source device 1 according to an embodiment of the present disclosure. The light source device 1 may include a support assembly 10, an excitation light source 20, and a wavelength conversion device 30. The excitation light source 20 may be configured to emit a light beam, the support assembly 10 is configured to change a traveling direction of the light beam emitted by the excitation light source 20, and the wavelength conversion device 30 may be configured to convert a wavelength of the excitation light source 20 into another wavelength, so as to satisfy subsequent use.

The embodiments of the present disclosure does not limit the specific form of the excitation light source 20. For example, the excitation light source 20 may be a xenon lamp, an ultra high pressure (UHP) mercury lamp, a laser diode (LD) lamp, a light emitting diode (LED) lamp, a fiber laser, a laser crystal and the like. The UHP mercury lamp and the LED lamp have the characteristic of long service life, and may maintain relatively good stability during a long-time operating process. The fiber laser and the laser crystal have relatively high output power, and the laser emitted by them has high reliability and high efficiency, while the LD lamp has the advantage of low cost. The specific form of the excitation light source 20 to be adopted may be selected according to actual requirements, which is not limited herein. The embodiments of the present disclosure also does not limit the specific structure of the wavelength conversion device 30. The wavelength conversion device 30 may be a grating wavelength meter, a spectrometer, a color wheel, etc., which is not limited herein, and may be specifically configured according to actual conditions. For example, in an embodiment, the wavelength conversion device 30 may adopt a phosphor sheet. The phosphor sheet has high conversion efficiency and a compact structure, as well as the characteristics of strong selectivity and good stability, which helps to maintain good stability during long-time use, thereby improving the light emitting precision of the light source device 1. In a more specific embodiment, the phosphor sheet may be composed of a matrix, an activator, a light emitting layer, a functional layer, and the like. The matrix is a substrate of the phosphor, generally some low-energy-state compounds, such as silicate, oxide, and the like. The function of the matrix is to provide a stable environment for the activator and a reflective interface for the excitation light. The activator and the light emitting layer may be arranged on the matrix. The activator is a key component for the light emission of the phosphor, generally some high-energy-state compounds, such as halides of alkali metals and alkaline earth metals. The light emitting layer is a light emitting region of the phosphor, and is generally formed by mixing the activator and the matrix according to a certain proportion. The thickness and proportion of the light emitting layer have a great influence on the light emitting performance of the phosphor.

The functional layer may be an electron transport layer, a hole transport layer, a protective layer, or the like. The electron transport layer is generally made of some materials having relatively high conductivity and thermal stability, such as oxide, and nitride. The function of the electron transport layer is to transmit excited-state electrons to the light emitting layer, thereby generating fluorescence. The hole transport layer is generally made of some materials having relatively high thermal stability and chemical stability, such as nitride, and silicide. The function of the hole transport layer is to transport holes in the light emitting layer to the light emitting layer, thereby realizing light emission. The protective layer is generally made of some materials having relatively high thermal stability and chemical stability, such as silicide, and nitride. The function of the protective layer is to protect the phosphor from being affected by environmental factors, and prolong the service life of the phosphor.

It should be noted that the specific structure and composition of the phosphor sheet are not limited in the embodiments of the present disclosure, and a user may select a suitable phosphor sheet according to actual requirements.

Referring to FIG. 2, which is a schematic structural diagram of a support assembly 10 according to an embodiment of the present disclosure, the support assembly 10 may include: a support member 110 and a light guiding element 120. The light guiding element 120 may be arranged on the support member 110 and configured to guide the traveling direction of the light beam emitted by the excitation light source 20. For example, the light guiding element 120 may be configured to reflect the traveling direction of the light beam incident on the light guiding element 120.

For example, referring to FIG. 2, the embodiments take the support member 110 being a platform-shaped structure as an example for description. The support member 110 may include a first bottom surface 111 and mounting surfaces 113. Each mounting surface 113 may be arranged obliquely relative to the first bottom surface 111. The support member 110 is provided with a mounting hole 113a, and the mounting hole 113a at least penetrates through the mounting surface 113. It should be noted that only one mounting surface 113 may also be provided, and providing a plurality of mounting surfaces 113 is conducive to improving the brightness of the light source device 1.

In an embodiment, the support member 110 further includes a first top surface 112 opposite to the first bottom surface 111. Two ends of the mounting surface 113 may be respectively connected to the first bottom surface 111 and the first top surface 112. In this case, the support member 110 may be a stepped platform or a structure similar to a stepped platform. Such structural arrangement of the support member 110 is conducive to improving the structural stability of the support member 110.

In some other embodiments, the support member 110 may further be configured as a conical structure or the like. In this case, the support member 110 may only include the first bottom surface 111 and the mounting surface 113. It should be noted that the specific structure of the support member 110 is not limited in the embodiments of the present disclosure, which may be specifically selected according to actual conditions.

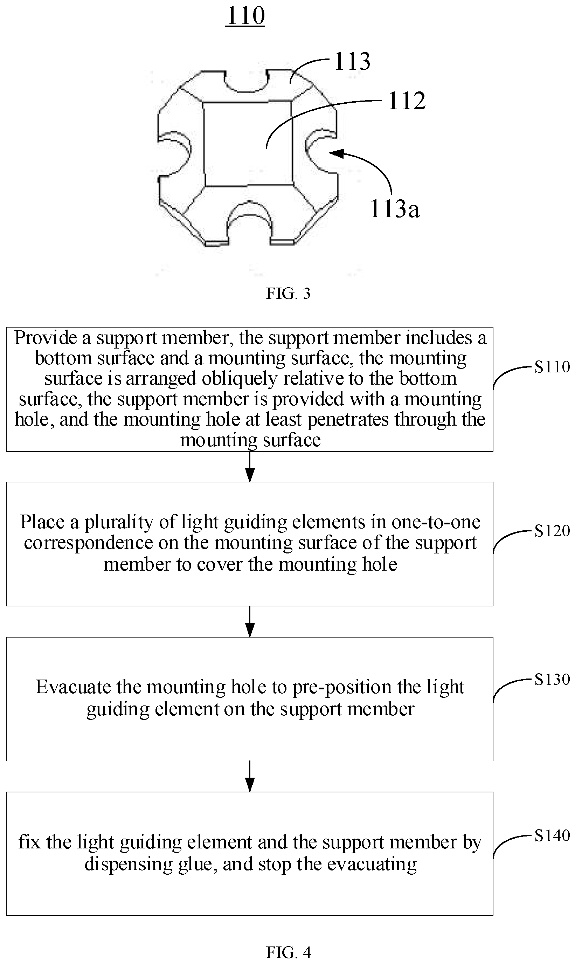

Referring to FIG. 3, FIG. 3 is a schematic structural diagram of a support member 110 in a support assembly 10 according to an embodiment of the present disclosure. It should be noted that the specific structure, size and the like of the mounting hole 113a are not limited in the embodiments of the present disclosure. For example, the mounting hole 113a may be a mounting hole 113a having a circular cross section, a mounting hole 113a having a square cross section, or a mounting hole 113a having an irregular cross section, etc., which may be specifically configured according to actual conditions.

In the embodiments of the present disclosure, the specific shapes of the first bottom surface 111, the first top surface 112, and the mounting surface 113 are not limited. For example, first bottom surface 111, the first top surface 112, and the mounting surface 113 may all be regular polygons. For example, the first bottom surface 111, the first top surface 112, and the mounting surface 113 may all be square. For another example, the first bottom surface 111 and the first top surface 112 may be regular triangles, and the mounting surface 113 may be square, which is not limited herein, and may be specifically selected according to actual conditions.

In addition, to facilitate the production of the support member 110 and more efficiently mount the support member 110 and the light guiding elements 120, the first bottom surface 111 and the first top surface 112 may be arranged in parallel. Further, the shapes and sizes of the plurality of mounting surfaces 113 may be configured to be consistent. In this way, the light guiding elements 120 may be quickly mounted in batches without distinguishing the specific orientation of the mounting surfaces 113, and without additionally establishing a one-to-one correspondence between each mounting surface 113 and each light guiding element 120, so as to simplify the assembly of the support member 110 and the light guiding element 120. Further, in an embodiment, cross sections of the plurality of mounting surfaces 113 enclose a regular polygonal structure.

In addition, referring to FIG. 1 and FIG. 2 at the same time, an inclination angle between each mounting surface 113 and the first bottom surface 111 may be configured to be equal. For example, the inclination angle between the mounting surface 113 and the first bottom surface 111 may be between 30° to 60°, such as 30°, 38°, 45°, 60°, etc., which is not limited herein, and may be specifically configured according to actual conditions. It may be understood that if the inclination angle between the mounting surface 113 and the first bottom surface 111 is too small, when the light emitting direction of the excitation light source 20 is parallel to the mounting surface 113, the width of the support member 110 in the light emitting direction of the excitation light source 20 (the X direction in the drawing) is too large, which is not conducive to the miniaturization of the entire support assembly 10. Similarly, if the inclination angle between the mounting surface 113 and the first bottom surface 111 is too large, when the light emitting direction of the excitation light source 20 is parallel to the mounting surface 113, the width of the support member 110 in the direction perpendicular to the light emitting direction of the excitation light source 20 (the Y direction in the drawing) will be too large, which is not conducive to the miniaturization of the entire support assembly 10.

In addition, different types of the light guiding elements 120 may also affect the above inclination angle. Since the types of the light guiding elements 120 are different, after each light guiding element 120 reflects the light beam, exit angles of the light beams are also different. Since the size of the wavelength conversion device is limited, the above inclination angle is controlled within a certain range to ensure that a plurality of light guiding elements can guide the light emitted from different directions to the same position on the wavelength conversion device.

It should be noted that the manufacturing material of the support member 110 is not limited in the embodiments of the present disclosure. For example, the support member 110 may be made of metal, alloy, plastic, wood, rubber, ceramic and other materials. In an embodiment, the support member 110 may be made of a ceramic material. Due to the relatively good thermal expansion coefficient and stability of the ceramic, the support member 110 may maintain good stability and is not prone to deformation under the long-time irradiation of the excitation light source 20. Therefore, the support member 110 made of the ceramic material may further improve the light guide accuracy of the support assembly 10. For example, the support member 110 may be made of composite ceramics such as zirconia-based composite ceramics or alumina-based composite ceramics, or may be made of thermal barrier ceramics such as thermal barrier coating ceramics or thermal barrier insulation ceramics, which is not limited herein, and may be selected according to actual conditions.

Continuing to refer to FIG. 2, the light guiding element 120 has a second bottom surface 121. The second bottom surface 121 may be arranged on the mounting surface 113 and cover the mounting hole 113a. The second bottom surface 121 covers the mounting hole 113a in a state where an air pressure inside the mounting hole 113a is less than an air pressure outside the mounting hole 113a. For example, the second bottom surface 121 may abut against and fit with the mounting surface 113, and the second bottom surface 121 completely covers the mounting hole 113a. The light guiding element 120 may be configured to reflect the light beam incident on the light guiding element 120.

It should be noted that, in the embodiments of the present disclosure, the manner of implementing that the air pressure inside the mounting hole 113a at the second bottom surface 121 is less than the air pressure outside the mounting hole 113a is not limited. For example, a evacuating operation may be performed inside the mounting hole 113a to make the air pressure inside the mounting hole 113a at the second bottom surface 121 less than the air pressure outside the mounting hole 113a.

In some embodiments, the mounting hole 113a may further penetrate through the first bottom surface 111, which may facilitate evacuating the mounting hole 113a, and further facilitate reducing the air pressure inside the mounting hole 113a.

In an embodiment, at least a partial region of the second bottom surface 121 is configured as a reflective surface. The specific forming manner of the second bottom surface 121 of the light guiding element 120 is not limited in the embodiments of the present disclosure, which may be specifically selected according to actual conditions. For example, it may be polishing, polishing one surface of the light guiding element 120 to a mirror state, which may be for example polishing using tools and materials such as abrasive, sandpaper, and polishing paste, so that the surface has a relatively high reflectivity, so as to form the second bottom surface 121. For another example, it may further be coating, coating one surface of the light guiding element 120 with a material layer having high reflectivity such as metal, glass, and plastic, so as to form the second bottom surface 121. For another example, it may also be surface treatment, changing the properties of one surface of the light guiding element 120 by chemical or physical methods to make it have a higher reflectivity, so as to form the second bottom surface 121. For example, a film having high reflectivity may be formed on one surface of the light guiding element 120 by methods such as anodizing, electroplating, and spraying.

It should be noted that the specific structure of the light guiding element 120 is not limited in the present disclosure. For example, the light guiding element 120 may be a hemispherical lens, a reflector, or the like.

For example, referring to FIG. 2 again, the area of the mounting hole 113a is smaller than the area of the second bottom surface 121, so that the light guiding element 120 can completely cover the mounting hole 113a, thereby facilitating the evacuating operation on the mounting hole 113a, and facilitating fixing the light guiding element 120 and the support member 110 by applying an adhesive after the evacuating.

In an embodiment, a plurality of light guiding elements 120 may be provided. It should be noted that the number of the light guiding elements 120 is not limited in the embodiments of the present disclosure, which may be specifically configured according to actual conditions and requirements, for example, four light guiding elements 120 as shown in the figure. The plurality of light guiding elements 120 may be configured to reflect light beams incident on each light guiding element 120 from different directions and converge the light beams in front of the first top surface 112. The "front" herein may be understood as a certain region on a side of the first top surface 112 away from the first bottom surface 111. The light beams reflected by the plurality of light guiding elements 120 will converge in the region. The specific position, shape or size of the region is not limited in the embodiments of the present disclosure.

Further, in some embodiments, the light guiding element 120 may further include a second top surface 122 opposite to the second bottom surface 121. The second top surface 122 may be configured to transmit the light beam, so that the light beam entering the light guiding element 120 can be emitted smoothly.

It should be noted that the specific structure of the second top surface 122 is not limited in the embodiments of the present disclosure. For example, the second top surface 122 may be a plane or a curved surface. When the second top surface 122 is configured as a curved surface, the second top surface 122 may also be configured to converge, diverge, or collimate a light beam, so as to improve the functional diversification of the light guiding element 120, which may be specifically configured according to actual requirements and is not limited herein.

In addition, in an embodiment, the second top surface 122 may be configured to transmit the light beam or reflect the light beam, which is not limited herein and may be specifically limited according to actual conditions.

For example, in an embodiment, the light guiding element 120 may be a reflector. Compared with reflective beads, reflective webbing, and the like, the reflector has the advantages such as high reflectivity, high optical quality, freely designable curved surface, and low cost. It should be noted that the specific type of the reflector is not limited in the embodiments of the present disclosure. For example, the reflector may be a plane reflector or a curved reflector.

The plane reflector has the characteristics of good reflection effect, clear imaging and simple structure. In addition, since the light beam is incident perpendicularly on the plane reflector, the propagation direction and the incident angle of the light beam can be ensured, so that the plane reflector can ensure the stability of imaging.

The curved reflector has the characteristics of high precision and low dispersion, and can shape the light beam at the same time. The curved reflector can shape the incident light beam into a desired shape, such as a circle or an ellipse. In addition, the curved reflector can reduce the size of the optical element while maintaining the optical performance, thereby reducing the weight and cost of the optical system.

It may be understood that, when the light guiding element 120 is a plane reflector, the plane reflector may be directly attached to the mounting surface 113 and cover the mounting hole 113a. When the light guiding element 120 is a curved reflector, the mounting hole 113a may extend to the edge of the mounting surface 113, for example, as shown in FIG. 3. In this case, the height difference fluctuation of the mounting hole 113a on the mounting surface 113 is more obvious, so as to facilitate the attachment of the curved reflector and the mounting surface 113.

In a more specific embodiment, the light guiding element 120 may be a hemispherical lens. The hemispherical lens may further focus a light spot of the light beam emitted by the excitation light source 20, making the light spot at the convergence point smaller. When the laser light beam converged onto the wavelength conversion device 30, which can improve the central brightness of the light emitted by the wavelength conversion device 30.

It should be noted that, the specific size of the hemispherical lens is not limited in the embodiments of the present disclosure. The diameter of the second bottom surface 121 of the hemispherical lens may be between 0.5 mm to 2 mm, for example, a hemispherical lens having the diameter of the second bottom surface 121 being 1.0 mm. It may be understood that the size of the hemispherical lens should not be too large or too small. If the size of the hemispherical lens is too large, the overall volume of the support assembly 10 may be increased, which is not conducive to the miniaturization of the support assembly 10. If the size of the hemispherical lens is too small, the size of the mounting hole 113a may be too small, which is not conducive to forming a hole in the support member 110, increasing the production and manufacturing difficulty of the support member 110 and thus increasing the cost. It can be understood that, in an embodiment, the lower part of the second bottom surface 121 of the hemispherical lens is hollowed out due to the arrangement of the mounting hole 113a, which reduces the interference of the total reflection on the hemispherical lens and further improves the light emitting accuracy of the light emitting element 120 of the support assembly 10.

Further, referring to FIG. 1 again, in an embodiment, the light source device 1 may further include a tube shell 40 and a light-transmissive upper cover 50.

The light-transmissive upper cover 50 is arranged on the tube shell 40 and encloses a closed space with the tube shell 40. The excitation light source 20 and the support assembly 10 are arranged in the closed space, and the excitation light reflected by the light guiding element 120 is incident to the wavelength conversion device 30 through the light-transmissive upper cover 50.

In an embodiment, the tube shell 40 may be of a box-shaped structure. The tube shell 40 may include a bottom plate 410 and side plates 420 connected to the bottom plate. The bottom plate 410 may be a rectangular plate, and four side plates 420 may be provided. The four side plates 420 are respectively connected to four edges of the bottom plate 410. In a more specific embodiment, the side plates 420 may be configured to have a consistent structure in shape and size to facilitate mold opening production. Further, the side plates 420 may be integrally formed with the bottom plate 410, which can simplify the mounting of the tube shell 40. The tube shell 40 may be made of a plastic material, which is low in cost and good in insulation, and may also be made of a metal material, which is good in chemical corrosion resistance and high in strength, which may be specifically selected according to actual conditions and is not limited herein.

The light-transmissive upper cover 50 may also be a rectangular plate structure, and the light-transmissive upper cover 50 may cover the side plates 420. In some embodiments, the size of the light-transmissive upper cover 50 may be slightly larger than the size of the bottom plate 420, which can ensure that the light-transmissive upper cover can completely seal the tube shell 40, and avoid the external environment from affecting the support assembly 10 arranged inside the tube shell 40, thereby ensuring the normal operation of the support assembly 10. The light-transmissive upper cover 50 may be made of a material such as a glass lens, a plastic lens, or a metal lens. The glass lens has a high refractive index and low dispersion, but the glass lens is relatively heavy and fragile. The plastic lens is relatively light, but has relatively low refractive index and dispersion performance. The metal lens has relatively high refractive index and relatively low dispersion, so as to provide high resolution and high quality images. However, the manufacturing cost of the metal lens is relatively high, which may be specifically selected according to actual conditions and is not limited herein.

The connection manner between the transparent upper cover and the tube shell 40 is not limited in the embodiments of the present disclosure. For example, it may be a detachable connection such as bonding or clamping, which facilitates the maintenance of the support assembly 10 arranged in the closed space.

For example, continuing to refer to FIG. 1, in an embodiment, the plane of the inner surface of the bottom plate 410 in the tube shell 40 may be parallel to both the first top surface 112 and the first bottom surface 111 of the support member 110. The excitation light source 20 may also be placed on the inner surface of the bottom plate 410 in the tube shell 40 and located on one side of the support assembly 10, which can simplify the internal structure of the light source device 1 and facilitate the assembly of the light source device 1.

Referring to FIG. 1 and FIG. 4 at the same time, an embodiment of the present disclosure further provides a method for assembling a support assembly 10. FIG. 4 shows a flowchart of a method for assembling a support assembly 10 according to an embodiment of the present disclosure. The method may include the following steps:
S110: a support member is provided. The support member has a bottom surface and a mounting surface. The mounting surface is arranged obliquely relative to the bottom surface, and the support member is provided with a mounting hole. The mounting hole at least penetrates through the mounting surface.
S120: a light guiding element is placed on the mounting surface of the support member to cover the mounting hole.

In some examples, a plurality of light guiding elements may be provided, and the plurality of light guiding elements placed in one-to-one correspondence on the mounting surfaces of the support member. The above one-to-one correspondence does not refer to a specific relationship, and may be understood as that one mounting hole 113a corresponding to one light guiding element 120. In this step, an external tool may be used to position the light guiding element 120 to make it located at a designated position, so as to ensure the accuracy of the exit direction of the light beam after the subsequent reflection of the excitation light beam by the light guiding element 120.

S130: evacuating the mounting hole to pre-position the light guiding element on the support member.

It can be understood that after the mounting hole 113a is vacuumed, the light guiding element 120 is fixed on the support member 110. At this time, if the position of the light guiding element 120 does not reach the expected position, the previous step can be repeated until the reflective element reaches the expected position, so as to improve the fault tolerance rate during the assembly of the support assembly 10.

S140: the light guiding element 120 is fixed to the support member by applying an adhesive, and the evacuating is stopped.

After the light guiding element 120 is located at the expected position, a glue dispensing process may be performed between the light guiding element 120 and the support member. For example, glue may be dispensed at the connection between the light guiding element 120 and the support member, so as to avoid glue covering an excessive area on the light guiding element 120, and to avoid changing a path of the light beam after exiting from the light guiding element 120 due to influence of the glue. It can be understood that the glue is not limited in the embodiments of the present disclosure. For example, ultraviolet curing glue, epoxy resin glue and the like may be used. After the glue is solidified, that is, after the light guiding element 120 is tightly connected to the support member, the evacuating may be stopped, so as to complete the assembly between one light guiding element 120 and the support member.

According to the support assembly 10 provided by the embodiments of the present disclosure, the mounting hole 113a is arranged on the mounting surface 113 of the support member 110, and the light guiding element 120 is arranged on the mounting surface 113 and covers the mounting hole 113a. When the second bottom surface 121 of the light guiding element 120 is in a state in which the air pressure inside the mounting hole 113a is less than the air pressure outside the mounting hole 113a, the light guiding element 120 can be pre-fixed to the support member 110, and then the support member 110 is fixed to the light guiding element 120 by applying an adhesive, thereby improving the accuracy of the arrangement position of the light guiding element 120, and further improving the reflection accuracy of the light guiding element 120. According to the method for assembling the support assembly 10 provided by the embodiments of the present disclosure, the support member 110 is first placed on the vacuum platform, then the light guiding elements 120 are placed in one-to-one correspondence on the mounting surfaces 113 of the support member 110 and cover the mounting hole 113a provided on the mounting surface 113, then the evacuating is performed on the mounting hole 113a to pre-position the light guiding element 120 on the support member 110, then the light guiding element 120 is fixed to the support member 110 by applying an adhesive between the light guiding element 120 and the support member 110, and finally the evacuating is stopped, thereby improving the convenience of assembling the support assembly 10. The light source device 1 applied to the support assembly 10 improves the light emitting accuracy.

In the present disclosure, unless otherwise explicitly specified or defined, terms such as "mounting" and "connection" should be understood in a broad sense. For example, it may be a fixed connection, a detachable connection, an integral connection, or a transmission connection. It may be a direct connection, or an indirect connection through an intermediate medium. For those of ordinary skill in the art, specific meanings of the above terms in the present disclosure may be understood based on specific situations.

In addition, terms such as "first" and "second" are merely used to distinguish description, and cannot be understood as referring to specific or special structures. The description of the term "some embodiments" means that particular features, structures, materials, or characteristics described in conjunction with the embodiments or examples are included in at least one embodiment or example of the present disclosure. In the present disclosure, the schematic expressions of the above terms are not necessarily directed to the same embodiment or example. In addition, the described specific features, structures, materials, or characteristics described can be combined in an appropriate way in any one or more embodiments or examples. In addition, those skilled in the art may combine and associate different embodiments or examples described in the present disclosure and features of different embodiments or examples, without conflicting with each other.

The above embodiments are only used to illustrate the technical solutions of the present disclosure, but not to limit the same. Although the present disclosure has been described in detail with reference to the above embodiments, a person of ordinary skill in the art should understand that: the technical solutions described in the above embodiments may still be modified, or some technical features thereof may be equivalently replaced. These modifications or substitutions do not make the essence of the corresponding technical solutions depart from the spirit and scope of the technical solutions of the embodiments of the present disclosure, and should all fall within the protection scope of the present disclosure.

## Claims

1. A support assembly, comprising:
a support member comprising a first bottom surface and a mounting surface, wherein the mounting surface is arranged obliquely relative to the first bottom surface, the support member is provided with a mounting hole, and the mounting hole at least penetrates through the mounting surface; and
a light guiding element comprising a second bottom surface, wherein the second bottom surface is provided on the mounting surface and covers the mounting hole, and wherein the second bottom surface is configured to cover the mounting hole in a state where an air pressure inside the mounting hole is less than an air pressure outside the mounting hole, and the light guiding element is configured to change a traveling direction of a light beam incident on the light guiding element.

2. The support assembly according to claim 1, wherein the air pressure inside the mounting hole at the second bottom surface being less than the air pressure outside the mounting hole comprises: the mounting hole is under vacuum.

3. The support assembly according to claim 1, wherein the mounting hole further penetrates through the first bottom surface.

4. The support assembly according to claim 1, wherein the support member further comprises a first top surface opposite to the first bottom surface, and wherein two ends of the mounting surface each are respectively connected to the first bottom surface and the first top surface.

5. The support assembly according to claim 1, wherein a cross section of the mounting surface encloses to form a regular polygonal structure.

6. The support assembly according to claim 1, wherein the light guiding element is further configured to converge the light beam incident on the light guiding element.

7. The support assembly according to claim 1, wherein a plurality of mounting surfaces and a plurality of light guiding elements are provided, the plurality of light guiding elements are in one-to-one correspondence with the plurality of mounting surfaces, and inclination angles between each of the mounting surfaces and a corresponding first bottom surface are equal.

8. The support assembly according to claim 1, wherein at least a partial region of the second bottom surface is configured as a reflective surface.

9. The support assembly according to claim 1, wherein the light guiding element further comprises a second top surface opposite to the second bottom surface.

10. The support assembly according to claim 9, wherein the second top surface is configured to transmit the light beam, and the second bottom surface is configured to reflect the light beam.

11. The support assembly according to claim 10, wherein the second top surface is configured as a curved surface, and is configured to converge, diverge or collimate the light beam.

12. The support assembly according to claim 9, wherein the second top surface is configured to reflect the light beam.

13. The support assembly according to claim 12, wherein the second top surface is configured as a plane; or the second top surface is configured as a curved surface, and is configured to converge, diverge or collimate the light beam.

14. The support assembly according to claim 1, wherein an area of the mounting hole is smaller than an area of the second bottom surface.

15. The support assembly according to claim 1, wherein the support member is made of ceramic.

16. A method for assembling a support assembly, comprising:
providing a support member, wherein the support member comprises a bottom surface and a mounting surface, the mounting surface is arranged obliquely relative to the bottom surface, the support member is provided with a mounting hole, and the mounting hole at least penetrates through the mounting surface;
placing a light guiding element on the mounting surface of the support member to cover the mounting hole;
evacuating the mounting hole to pre-position the light guiding element on the support member;
fixing the light guiding element and the support member by applying an adhesive; and
stopping the evacuating.

17. A light source device, comprising:
an excitation light source configured to emit excitation light;
a wavelength conversion device configured to convert at least part of the excitation light into converted light; and
the support assembly according to any one of claims 1 to 15, wherein the support assembly is arranged on an optical path of the excitation light, and the light guiding element is configured to change a traveling direction of the excitation light to point to the wavelength conversion device.

18. The light source device according to claim 17, further comprising:
a tube shell; and
a light-transmissive upper cover disposed on the tube shell and forming a closed space together with the tube shell, wherein the excitation light source and the support assembly are arranged in the closed space, and the excitation light reflected by the light guiding element is incident to the wavelength conversion device through the light-transmissive upper cover.
